# EUROPÄISCHE PATENTSCHRIFT

(11) **EP 3 143 482 B1**
(45) Veröffentlichungstag und Bekanntmachung des Hinweises auf die Patenterteilung: **04.07.2018**
(21) Anmeldenummer: 15722191.2
(22) Anmeldetag: 12.05.2015
(51) Int. Cl.: G06F 3/041, G01R 27/26, G06F 3/044, H03K 17/96

(54) **VERFAHREN ZUM MESSEN EINES KAPAZITÄTSWERTES**
METHOD OF MEASURING A CAPACITY VALUE
PROCEDE DE MESURE D'UNE VALEUR DE CAPACITE

(30) Priorität: 16.05.2014 DE 102014007236
(43) Veröffentlichungstag der Anmeldung: 22.03.2017
(73) Patentinhaber: Leopold Kostal GmbH & Co. KG, 58513 Lüdenscheid (DE)
(72) Erfinder: BORGMANN, Uwe, 45665 Recklinghausen (DE); LEXOW, Carl Christian, 44287 Dortmund (DE)
(74) Vertreter: Kerkmann, Detlef
(86) Internationale Anmeldenummer: PCT/EP2015/060474
(87) Internationale Veröffentlichungsnummer: WO 2015/173241

(56) Entgegenhaltungen:
- EP-A1- 2 717 136
- DE-A1-102010 041 464
- US-A1- 2011 261 006

## Beschreibung

Die Erfindung betrifft ein Verfahren zum Messen eines Kapazitätswertes C_{M} eines kapazitiven Sensorelements mittels eines Integrationsverfahrens, wobei ein Anschluss des Sensorelements mit einem ersten Anschluss eines Integrationskondensators mit einem bekannten Kapazitätswert C_{I}, welcher groß gegenüber dem Kapazitätswert C_{M} des Sensorelements ist, an einem gemeinsamen Schaltungsknoten elektrisch verbunden ist, und wobei nach einer Zahl IZ durchgeführter Integrationszyklen eine an dem Integrationskondensator anliegende Spannung U_{CI} mittels eines A/D-Wandlers gemessen wird.

Verfahren der hier angesprochenen Art werden verwendet um kapazitive Berührungs- bzw. Annäherungssensoren auszuwerten. Ein solcher Sensor kann die Gegenwart und bei entsprechender Ausgestaltung auch den Ort einer Berührung oder der Annäherung durch ein Objekt, wie zum Beispiel einen Finger des Benutzers oder einen Stift, innerhalb eines empfindlichen Bereichs detektieren. Der berührungsempfindliche Bereich kann dabei beispielsweise einen Anzeigebildschirm überlagern. In einer Anzeigeanwendung kann es der Berührungs- bzw. Annäherungssensor dem Benutzer ermöglichen, direkt mit dem, was auf dem Bildschirm dargestellt wird, zu interagieren, und nicht nur indirekt mittels einer Maus oder einem ähnlichen Eingabegerät.
Es gibt eine Anzahl verschiedener Arten von Berührungssensoren, wie zum Beispiel resistive Berührungssensoren, Berührungssensoren mit akustischen Oberflächenwellen und kapazitive Berührungssensoren, wobei letztgenannte, mit denen eben insbesondere auch schon eine bloße Annäherung erfasst werden kann, inzwischen die größte Verbreitung erfahren haben.

Wenn ein Objekt die Oberfläche eines kapazitiven Berührungssensors berührt oder in dessen Nähe kommt, tritt eine Änderung des Kapazitätswertes des Sensors auf. Aufgabe eines zugeordneten Sensorsteuergerätes bzw. des durch dieses verwendeten Messverfahrens ist es, diese Kapazitätsänderung zu verarbeiten, um die diese auslösende Berührung oder Annäherung zu erfassen. Die besondere Schwierigkeit hierbei besteht darin, dass die Kapazitätswerte der Sensoren und insbesondere die zu erfassenden Änderungen sehr klein sind. Aus diesem Grunde bedient man sich zu ihrer Messung gerne sogenannter Integrationsverfahren, bei denen in mehreren aufeinander folgenden Zyklen kleine Ladungsmengen von dem Sensorelement, dessen Kapazitätswert relativ klein und veränderlich ist, auf einen Integrationskondensator mit einem bekannten festen und deutlich größeren Kapazitätswert übertragen werden.

Durch die Offenlegungsschrift US 2011/261006 A1 ist ein Verfahren zum Messen eines Kapazitätswertes eines kapazitiven Sensorelements gemäß dem Oberbegriff des Patentanspruchs 1 bekannt geworden. Bei dem hier beschriebenen Verfahren zum Messen eines Kapazitätswertes handelt es sich um ein Integrationsverfahren der gerade angesprochenen Art, wobei ein Anschluss des Sensorelements mit einem ersten Anschluss des Integrationskondensators an einem gemeinsamen Schaltungsknoten elektrisch verbunden ist.

Zur Durchführung der Messung werden verschiedene Methoden verwendet. So kann beispielsweise nach Durchführung einer fest vorgegebenen Anzahl sogenannter Integrationszyklen die aus der Summe der dabei erfolgten Ladungstransfers resultierende, an dem Integrationskondensator anliegende Spannung mittels eines A/D-Wandlers gemessen und digitalisiert werden. Als Ergebnis der Messung wird die gemessene Spannung selbst, bzw. deren digitalisierter Wert, oder der aus diesem Wert und den bekannten konstanten Größen Kapazität des Integrationskondensators, Versorgungsspannung und Anzahl der Integrationszyklen berechnete Wert der Messkapazität verwendet. Alternativ hierzu kann aber auch in jedem einzelnen Integrationszyklus die an dem Integrationskondensator anliegende Spannung gemessen und bei Erreichen eines vorgegebenen Schwellwertes die Messung beendet werden. Die Messgröße ist in diesem Fall dann die bis zum Erreichen der Schwellwertspannung durchgeführte Anzahl von Integrationszyklen.

Die Auflösung dieser Messverfahren und damit die Grenze für die Unterscheidbarkeit zweier Zustände, bzw. Kapazitätswerte ist maßgeblich durch die Auflösung des verwendeten A/D-Wandlers bestimmt. Durch einen A/D-Wandler können Spannungen nur in bestimmten diskreten Stufungen erfasst werden. Diese Stufen werden auch als Quantisierungsintervalle bezeichnet. Der zu messende Bereich wird also quantisiert, d.h. in diskrete Bereiche, in diesem Falle also Spannungsstufen aufgeteilt. Bei einer Messung wird dann der wahren, also analog gemessenen Spannung der Wert der nächst höheren oder tieferen Stufe als digitaler Messwert zugeordnet, je nachdem welcher dieser Stufen er näher liegt. Die Abweichung der wahren Spannung von der durch den A/D-Wandler ausgegebenen Spannungsstufe ist der Quantisierungsfehler. Sofern im Folgenden also von dem durch den A/D-Wandler gemessenen Spannungswert die Rede ist, ist damit jeweils der digitale Wert der durch den A/D-Wandler ausgegebenen Spannungsstufe gemeint.

Das Verfahren gemäß der vorliegenden Erfindung hat gegenüber dem zuvor beschriebenen den Vorteil, bei identischer Auflösung des A/D-Wandlers eine höhere Auflösung des Messergebnisses zu erreichen.

Dies gelingt erfindungsgemäß durch die Verfahrensschritte:
a) Festlegen einer Anzahl N durchzuführender Integrationszyklen auf einen Startwert N_{Start} und Bestimmen eines Endwertes N_{End} für die Anzahl N durchzuführender Integrationszyklen
b) Initialisieren eines Spannungssummenwerts U_{Ges} auf den Wert Null
c) Initialisieren der Zahl IZ durchgeführter Integrationszyklen auf den Wert Null
d) Durchführen des Integrationsverfahrens bis die Zahl IZ durchgeführter Integrationszyklen die Anzahl N durchzuführender Integrationszyklen erreicht hat
e) Addieren des mittels des A/D-Wandlers aktuell bestimmten Spannungswertes U_{CI}(N) zu dem Spannungssummenwert U_{Ges}
f) Erhöhen der Anzahl N um einen Wert n, wobei n größer oder gleich 1 und kleiner als N_{Diff} = N_{End} - N_{Start} ist, und Wiederholung der Verfahrensschritte ab Schritt c) bis die Anzahl N den bestimmten Endwert N_{End} überschreitet
g) Auswertung des Spannungssummenwerts U_{Ges} als Messergebnis.

In einer vorteilhaften Ausgestaltung des erfindungsgemäßen Verfahrens ist vorgesehen, dass das Integrationsverfahren die folgenden Verfahrensschritte umfasst:
d1) Verbinden des gemeinsamen Schaltungsknotens (3) und des zweiten Anschlusses (2") des Integrationskondensators (2) mit einem Massepotential GND
d2) Anlegen einer bekannten Versorgungsspannung U_{V} an den gemeinsamen Schaltungsknoten (3), wobei gleichzeitig der zweite Anschluss (2") des Integrationskondensators (2) potentialfrei gehalten wird
d3) Trennen der Versorgungsspannung U_{V} von dem gemeinsamen Schaltungsknoten (3), wobei gleichzeitig der zweite Anschluss (2") des Integrationskondensators (2) mit dem Massepotential GND verbunden wird
d4) Erhöhen der Zahl IZ durchgeführter Integrationszyklen um den Wert Eins und Wiederholung der Verfahrensschritte ab Schritt d2) bis die Zahl IZ durchgeführter Integrationszyklen die aktuell vorgegebene Anzahl N durchzuführender Integrationszyklen erreicht hat
d5) Messen der an dem Integrationskondensator (2) anliegenden Spannung U_{CI}(N) mittels des A/D-Wandlers (4).

Nachfolgend ist die Erfindung unter Bezugnahme auf die beigefügte Zeichnung erläutert.

Dabei zeigen:
- **Fig. 1:**: a) eine schematische Darstellung der Messanordnung zur Durchführung des erfindungsgemäßen Verfahrens
b) eine Darstellung der zeitlichen Abfolge einer Integration mit N Integrationszyklen als Timing-Diagramm der Schalter aus a)
- **Fig. 2:**: den Verlauf der an dem Integrationskondensator anliegenden Spannung U_{CI}(N) als Funktion der Anzahl N der Integrationszyklen

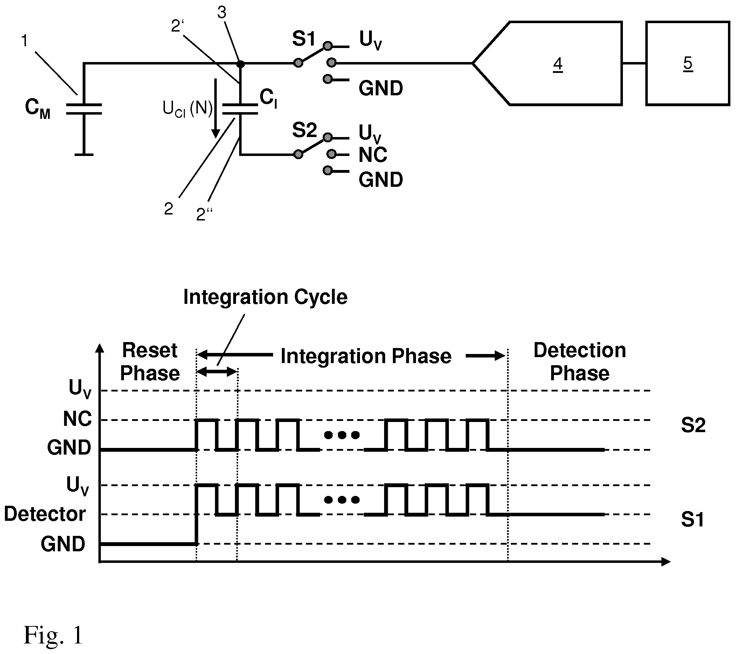

Die Zeichnung zeigt in Fig. 1a) eine Messanordnung zur Durchführung des erfindungsgemäßen Verfahrens zum Messen eines Kapazitätswertes C_{M} eines kapazitiven Sensorelements 1 in einer schematischen Darstellung als Schaltbild. Das Sensorelement 1 bildet dabei beispielsweise einen Berührungssensor aus, etwa in Form einer Elektrode, die eine Eigenkapazität mit einem Kapazitätswert C_{M} bezüglich einem relativen Masse- oder Erdpotential hat. Bei Berührung oder Annäherung der Elektrode z.B. durch einen Finger des Benutzers ändert sich dieser Kapazitätswert C_{M} durch die Berührungskapazität, die dieser bezüglich dem Masse- oder Erdpotential aufweist.

Ein Anschluss des Sensorelements 1 ist an einem gemeinsamen Schaltungsknoten 3 mit einem ersten Anschluss 2' eines Integrationskondensators 2 elektrisch verbunden. Der bekannte Kapazitätswert C_{I} des Integrationskondensators 2 ist dabei groß gegenüber dem zu ermittelnden Kapazitätswert C_{M} des Sensorelements 1. Der gemeinsame Schaltungsknoten 3 ist weiterhin mit einem ersten Schalter S1 verbunden und über diesen je nach Schalterstellung wahlweise mit dem Masse- oder Erdpotential GND, mit einer festen Versorgungsspannung U_{V} oder mit einem Eingang eines A/D-Wandlers 4 verbindbar. Ein zweiter Anschluss 2" des Integrationskondensators 2 ist elektrisch mit einem zweiten Schalter S2 verbunden und über diesen je nach Schalterstellung wahlweise mit dem Masse- oder Erdpotential GND oder mit der festen Versorgungsspannung U_{V} verbindbar oder potentialfrei, also offen gehalten (NC).

Zur Messung des Kapazitätswerts C_{M} wird ein grundsätzlich bekanntes Integrationsverfahren angewendet, bei dem in mehreren aufeinander folgenden Zyklen kleine Ladungsmengen von dem Sensorelement 1 auf den Integrationskondensator 2 übertragen werden. Nach einer Anzahl N dieser als Integrationszyklen bezeichneten Ladungstransfers wird die dann an dem Integrationskondensator 2 anliegende Spannung U_{CI}(N) mittels des A/D-Wandlers 4 gemessen. Die Spannung U_{CI}(N) ist direkt proportional dem Kapazitätswert C_{M} und somit ein Maß für diesen. Ein beispielhafter Ablauf eines solchen Integrationsverfahrens wird anhand des in Fig. 1b) wiedergegebenen Timing-Diagramms der Schalter S1 und S2 aus der Fig. 1a) beschrieben:
Zur Initialisierung des Messvorgangs werden der mit dem ersten Anschluss 2' des Integrationskondensators 2 verbundene, gemeinsame Schaltungsknoten 3 und der zweite Anschluss 2" des Integrationskondensators 2 mit dem Massepotential verbunden, und damit die Spannung U_{CI}(0) über dem Integrationskondensator 2 zu Null gesetzt (Reset Phase).

Die folgenden Schritte beschreiben einen Integrationszyklus (Integration Cycle):
An den gemeinsamen Schaltungsknoten 3 wird mittels des Schalters S1 die Versorgungsspannung U_{V} angelegt, wobei gleichzeitig der zweite Anschluss 2" des Integrationskondensators 2 mittels des Schalters S2 offen und somit potentialfrei gehalten wird. Dann wird die Versorgungsspannung U_{V} mittels des Schalters S1 von dem gemeinsamen Schaltungsknoten 3 getrennt und potentialfrei gehalten, wobei gleichzeitig der zweite Anschluss 2" des Integrationskondensators 2 mittels des Schalters S2 mit dem Massepotential GND verbunden wird.

Im Verlauf einer Messung werden die Schritte dieses Integrationszyklus wiederholt durchgeführt, und zwar so oft, bis die durchgeführte Zahl IZ von Integrationszyklen eine vorgegebene Anzahl N erreicht hat (Integration Phase).

Im Anschluss daran wird die an dem Integrationskondensator 2 nach diesen N Integrationszyklen anliegende Spannung U_{CI}(N) mittels des A/D-Wandlers 4 gemessen, indem der gemeinsame Schaltungsknoten 3 mittels des Schalters S1 mit dem Eingang des A/D-Wandlers 4 verbunden wird (Detection Phase).

Der gemessene (digitale) Spannungswert U_{CI}(N) wird zur weiteren Verarbeitung und Auswertung an eine Steuer- und Auswerteeinrichtung 5 übermittelt. Die Steuer- und Auswerteeinrichtung 5 steuert den Ablauf des gesamten beschriebenen Verfahrens und umfasst dazu als zentrales Element etwa einen Mikrocontroller.

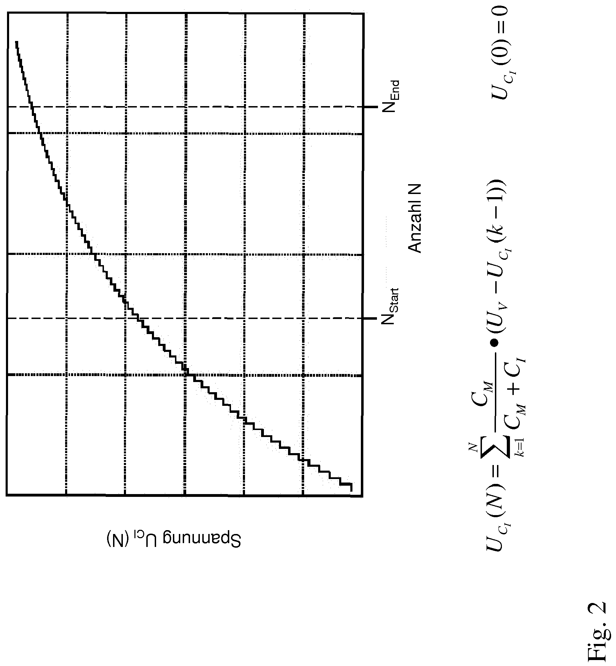

Gemäß der vorliegenden Erfindung ist die gerade beschriebene Messung mit N Integrationszyklen Bestandteil eines übergeordneten Ablaufs, der mehrere solcher Messungen mit jeweils unterschiedlichen Werten der durchzuführenden Anzahl N von Integrationszyklen umfasst, und zwar in der folgenden Weise, die auch aus der in Fig. 2 wiedergegebenen Darstellung des Verlaufs der an dem Integrationskondensator 2 anliegenden Spannung U_{CI}(N) als Funktion der Anzahl N der Integrationszyklen deutlich wird:
Zunächst wird die Anzahl N der durchzuführenden Integrationszyklen auf einen Startwert N_{Start} für die erste Messung im Rahmen des übergeordneten Ablaufs festgelegt. Gleichzeitig wird ein Ziel- bzw. Endwert N_{End} für die maximal durchzuführende Anzahl N von Integrationszyklen für die letzte Messung im Rahmen des übergeordneten Ablaufs bestimmt. Ein Spannungssummenwert U_{Ges} wird initialisiert auf den Wert Null.

Die Zahl IZ durchgeführter Integrationszyklen wird eingangs auf den Wert Null initialisiert. Anschließend wird das oben beschriebene Integrationsverfahren ausgeführt, und zwar so lange, bis die Zahl IZ durchgeführter Integrationszyklen, die bei jeder Durchführung um den Wert Eins erhöht wird, die aktuell gültige Anzahl N durchzuführender Integrationszyklen erreicht hat. Mittels des A/D-Wandlers wird daraufhin der an dem Integrationskondensator 2 anliegende Spannungswert U_{CI}(N) bestimmt und dieser zu dem aktuell gültigen Spannungssummenwert U_{Ges} addiert.

Danach wird die Anzahl N der durchzuführenden Integrationszyklen um einen Wert n erhöht und die im vorhergehenden Absatz beschriebenen Schritte mit der neuen Anzahl N wiederholt. Der Erhöhungswert n ist dabei mindestens gleich 1 und kleiner als die Differenz N_{Diff} = N_{End} - N_{Start} zwischen dem Startwert N_{Start} und dem Ziel- bzw. Endwert N_{End}. Um eine nicht zu geringe Menge von Messungen mit jeweils N Integrationszyklen als Bestandteil des übergeordneten Ablaufs zu erhalten, wird der Erhöhungswert n in der Regel deutlich kleiner als N_{Diff} gewählt werden. Er kann dabei entweder von Schritt zu Schritt variieren oder aber einen konstanten Wert von z.B. n=1, n=3 oder n=4 annehmen. Die Wiederholung des im vorhergehenden Absatz beschriebenen Schritts mit der neuen Anzahl N erfolgt so oft, bis die Anzahl N den eingangs bestimmten Endwert N_{End} überschreitet.

Der bis zu diesem Zeitpunkt aufaddierte Spannungssummenwert U_{Ges} wird dann als Messergebnis ausgewertet.

In den Spannungssummenwert U_{Ges} gehen dabei die einzelnen gemessenen Spannungswerte U_{CI}(N) als Summanden ein. Jeder dieser Spannungswerte U_{CI}(N) wurde dabei durch den A/D-Wandler 4 bestimmt und ist daher, wie bereits zuvor erläutert, mit einem Quantisierungsfehler behaftet. Dabei verläuft die Quantisierung linear über den Messbereich, d.h. die Stufenhöhe der durch den A/D-Wandler 4 ausgegebenen Spannungsstufen ist jeweils gleich. Da der Verlauf der an dem Integrationskondensator 2 anliegenden Spannung U_{CI}(N) als Funktion der Anzahl N der Integrationszyklen hingegen, wie in Fig. 2 zu erkennen, nichtlinear ist, ergibt sich eine statistische Verteilung der Quantisierungsfehler, die in der Summe zu einer zumindest teilweisen Kompensation derselben führt.

## Patentansprüche

1. Verfahren zum Messen eines Kapazitätswertes CM eines kapazitiven Sensorelements (1) mittels eines Integrationsverfahrens, wobei ein Anschluss des Sensorelements mit einem ersten Anschluss (2') eines Integrationskondensators (2) mit einem bekannten Kapazitätswert C_{I}, welcher groß gegenüber dem Kapazitätswert C_{M} des Sensorelements (1) ist, an einem gemeinsamen Schaltungsknoten (3) elektrisch verbunden ist, und wobei nach einer Zahl IZ durchgeführter Integrationszyklen eine an dem Integrationskondensator (2) anliegende Spannung U_{CI} mittels eines A/D-Wandlers (4) gemessen wird, **gekennzeichnet durch** die Verfahrensschritte:
a) Festlegen einer Anzahl N durchzuführender Integrationszyklen auf einen Startwert N_{Start} und Bestimmen eines Endwertes N_{End} für die Anzahl N durchzuführender Integrationszyklen
b) Initialisieren eines Spannungssummenwerts U_{Ges} auf den Wert Null
c) Initialisieren der Zahl IZ durchgeführter Integrationszyklen auf den Wert Null
d) Durchführen des Integrationsverfahrens bis die Zahl IZ durchgeführter Integrationszyklen die Anzahl N durchzuführender Integrationszyklen erreicht hat
e) Addieren des mittels des A/D-Wandlers aktuell bestimmten Spannungswertes U_{CI}(N) zu dem Spannungssummenwert U_{Ges}
f) Erhöhen der Anzahl N um einen Wert n, wobei n größer oder gleich 1 und kleiner als N_{Diff} = N_{End} - N_{Start} ist, und Wiederholung der Verfahrensschritte ab Schritt c) bis die Anzahl N den bestimmten Endwert N_{End} überschreitet
g) Auswertung des Spannungssummenwerts U_{Ges} als Messergebnis.

2. Verfahren nach Anspruch 1, **dadurch gekennzeichnet, dass** der Wert n der Erhöhung ein konstanter Wert ist.

3. Verfahren nach Anspruch 1, **dadurch gekennzeichnet, dass** der Wert n der Erhöhung von Schritt zu Schritt variiert.

4. Verfahren nach einem der Ansprüche 1 bis 3, **dadurch gekennzeichnet, dass** das Integrationsverfahren die folgenden Verfahrensschritte umfasst:
d1) Verbinden des gemeinsamen Schaltungsknotens (3) und des zweiten Anschlusses (2") des Integrationskondensators (2) mit einem Massepotential GND
d2) Anlegen einer bekannten Versorgungsspannung Uv an den gemeinsamen Schaltungsknoten (3), wobei gleichzeitig der zweite Anschluss (2") des Integrationskondensators (2) potentialfrei gehalten wird
d3) Trennen der Versorgungsspannung U_{V} von dem gemeinsamen Schaltungsknoten (3), wobei gleichzeitig der zweite Anschluss (2") des Integrationskondensators (2) mit dem Massepotential GND verbunden wird
d4) Erhöhen der Zahl IZ durchgeführter Integrationszyklen um den Wert Eins und Wiederholung der Verfahrensschritte ab Schritt d2) bis die Zahl IZ durchgeführter Integrationszyklen die aktuell vorgegebene Anzahl N durchzuführender Integrationszyklen erreicht hat
d5) Messen der an dem Integrationskondensator (2) anliegenden Spannung U_{CI}(N) mittels des A/D-Wandlers (4).

## Claims

1. Process for measuring a capacitance value CM of a capacitive sensor element (1) by means of an integration method, whereby one terminal of the sensor element is electrically connected at a common circuit node (3) to a first terminal (2') of an integration capacitor (2) having a known capacitance value C_{I} which is great in comparison with the capacitance value C_{M} of the sensor element (1), and whereby, after a number IZ of executed integration cycles, a voltage U_{CI} applied to the integration capacitor (2) is measured by means of an A/D converter (4), **characterised by** the process steps:
a) Setting a number N of integration cycles to be executed to a start value N_{Start} and determining an end value N_{End} for the number N of integration cycles to be executed,
b) Initialising a voltage sum value U_{Ges} at the zero value,
c) Initialising the number IZ of executed integration cycles at the zero value,
d) Conducting the integration process until the number IZ of executed integration cycles has reached the number N of integration cycles to be executed,
e) Adding the voltage value U_{CI}(N) currently determined by the A/D converter to the voltage sum value U_{Ges},
f) Increasing the number N by a value n, whereby n is greater than or equal to 1 and smaller than N_{Diff} = N_{End} - N_{Start}, and repeating the process steps from step c) on until the number N exceeds the determined end value (N_{End}),
g) Analysing the voltage sum value U_{Ges} as the measurement result.

2. Process according to Claim 1, **characterised in that** the value n of the increase is a constant value.

3. Process according to Claim 1, **characterised in that** the value n of the increase varies from step to step.

4. Process according to any of Claims 1 to 3, **characterised in that** the integration process comprises the following process steps:
d1) Connecting the common circuit node (3) and the second terminal (2") of the integration capacitor (2) to a ground potential GND,
d2) Applying a known supply voltage Uᵥ to the common circuit node (3) while, at the same time, the second terminal (2") of the integration capacitor (2) is kept potential-free,
d3) Disconnecting the supply voltage Uᵥ from the common circuit node (3) while, at the same time, the second terminal (2") of the integration capacitor (2) is connected to the mass potential GND,
d4) Increasing the number IZ of executed integration cycles by the value one and repeating the process steps from step d2) until the number IZ of executed integration cycles has reached the currently prescribed number N of integration cycles to be executed,
d5) Measurement of the voltage U_{CI}(N) applied to the integration capacitor (2) by means of the A/D converter (4).

## Revendications

1. Procédé de mesure d'une valeur de capacité CM d'un élément capteur (1) au moyen d'un procédé d'intégration, sachant que le raccord de l'élément capteur (1) à un premier raccord (2') d'un condensateur d'intégration (2) avec une valeur de capacité connue C_{I}, grande par rapport à la valeur de capacité C_{M} de l'élément capteur (1) est relié électriquement à un noeud de commutation (3), et sachant que, après un nombre IZ de cycles d'intégration exécutés, une tension Uci, appliquée sur le condensateur d'intégration (2), est mesurée au moyen d'un convertisseur A/N (4),
**caractérisé par** les étapes de procédé suivantes:
a) Fixation d'un nombre N de cycles d'intégration à exécuter à une valeur de départ N_{Start} et détermination d'une valeur finale N_{End} pour le nombre N des cycles d'intégration à exécuter
b) Initialisation à la valeur zéro d'une valeur de la somme de tension U_{Ges}
c) Initialisation à la valeur zéro du nombre IZ des cycles d'intégration exécutés
d) Exécution du procédé d'intégration jusqu"à ce que le nombre IZ des cycles d'intégration exécutés ait atteint le nombre N des cycles d'intégration à exécuter
e) Addition de la valeur de tension U_{CI}(N), actuellement déterminée au moyen du convertisseur A/N, et de la valeur de la somme de tension U_{Ges}
f) Augmentation du nombre N d'une valeur n, sachant que n est supérieur ou égal à 1 et inférieur à N_{Diff} = N_{End} - N_{Start}, et répétition des étapes de procédé à partir de l'étape c), jusqu'à ce que le nombre N surpasse la valeur finale N_{End})
g) Evaluation de la valeur de la somme de tension U_{Ges} en tant que résultat de mesure.

2. Procédé selon la revendication 1, **caractérisé en ce que** la valeur n de l'augmentation est une valeur constante.

3. Procédé selon la revendication 1, **caractérisé en ce que** la valeur n de l'augmentation varie d'étape en étape.

4. Procédé selon l'une des revendications 1 à 3, **caractérisé en ce que** le procédé d'intégration comprend les étapes suivantes:
d1) Liaison du noeud de commutation (3) commun et du deuxième raccord (2") du condensateur d'intégration (2) à un potentiel de masse GND
d2) Application d'une tension d'alimentation connue U_{V} au noeud de commutation (3) commun, sachant que, simultanément, le deuxième raccord (2") du condensateur d'intégration (2) est maintenu exempt de potentiel
d3) Séparation de la tension d'alimentation connue U_{V} et du noeud de commutation (3) commun, sachant que, simultanément, le deuxième raccord (2") du condensateur d'intégration (2) est relié au potentiel de masse GND
d4) Augmentation du nombre IZ des cycles d'intégration exécutés de la valeur un et répétition des étapes de procédé à partir de l'étape d2), jusqu'à ce que le nombre IZ des cycles d'intégration exécutés ait atteint le nombre N actuellement prédéterminé des cycles d'intégration à exécuter
d5) Mesure de la tension U_{CI}(N) appliquée sur le condensateur d'intégration (2) au moyen du convertisseur A/N (4).
